(19) Europäisches Patentamt
European Patent Office
Office européen des brevets

(11) **EP 1 912 330 B1**

(12) **EUROPEAN PATENT SPECIFICATION**

(45) Date of publication and mention
of the grant of the patent:
**25.11.2009 Bulletin 2009/48**

(51) Int Cl.:
*H03K 3/00* *(2006.01)*   *H03K 23/00* *(2006.01)*
*G06F 1/00* *(2006.01)*

(21) Application number: **06255221.1**

(22) Date of filing: **11.10.2006**

(54) **Spread-period clock generator**

Taktgenerator mit verteilter Periode

Générateur d'horloge à étalement de période

(84) Designated Contracting States:
**DE FR GB**

(72) Inventor: **Szajnowski, Wieslaw Jerzy**
**Guildford**
**Surrey GU1 2AR (GB)**

(43) Date of publication of application:
**16.04.2008 Bulletin 2008/16**

(74) Representative: **Brinck, David John Borchardt et al**
**R.G.C. Jenkins & Co**
**26 Caxton Street**
**London SW1H 0RJ (GB)**

(73) Proprietors:
• **Mitsubishi Electric Information Technology**
**Centre**
**Europe B.V.**
**Guildford,**
**Surrey GU2 7YD (GB)**
Designated Contracting States:
**GB**
• **MITSUBISHI DENKI KABUSHIKI KAISHA**
**Chiyoda-ku, Tokyo 100-8310 (JP)**
Designated Contracting States:
**DE FR**

(56) References cited:
**FR-A1- 2 839 827     US-A1- 2004 263 221**

• **"DS1086 Spread-Spectrum EconOscillator"**
**2002, MAXIM INTEGRATED PRODUCTS , USA ,**
**XP002418918 * the whole document ***
• **"Multiphase Oscillator with Spread spectrum**
**Frequency Modulation" 2003, LINEAR**
**TECHNOLOGY CORPORATION , USA ,**
**XP002418948 * the whole document ***

**Description**

BACKGROUND OF THE INVENTION

Field of the Invention

This invention relates to a method and apparatus for generating pulse trains with variable interpulse intervals, for example to be employed to drive suitable waveform generators utilized in multi-user active sensor systems and particularly, but not exclusively, in automotive radar systems designed to perform functions of obstacle-detection and/or collision avoidance.

Description of the Prior Art

In a multi-user environment, active sensors may transmit their interrogating signals simultaneously and asynchronously so that not only must each receiver recognize and detect a response to its own transmitted signal, but it must be able to do so in the presence of all other transmitted signals.

For example, in automotive applications, many similar obstacle-detection systems should be capable of operating in the same region, and also be capable of sharing the same frequency band. To avoid mutual interference, each sensor system should use a distinct signal, preferably uncorrelated with the signals employed by all other systems. Because it is not possible to predict which of the many similar systems will be operating in a particular environment, it is not practical to assign a distinct waveform to each of them.

The problem of constructing a large set of distinct waveforms from a single underlying 'template' waveform can be solved, at least partly, by exploiting in a judicious way some random or pseudorandom mechanism in the process of the waveform construction.

One practical approach may exploit the principle of driving a digital waveform generator by clock pulses with random (or pseudo-random) parameters.

Although the *same* digital waveform generator will be employed for producing a plurality of waveforms, each waveform will be *distinct,* having resulted from a clock pulse train with different characteristics. In this context, the waveform generator itself can be viewed as a mapping device applied to convert a set of different realizations of a randomised pulse train into a corresponding set of distinct waveforms.

The suitability of such obtained waveforms to multi-user applications will depend on the autocorrelation properties of the underlying 'template' waveform, and also on the statistical distribution of frequency (or period) of the employed clock generator. Therefore, the availability of clock generators with suitably randomised frequency or period is of practical importance in multi-user sensor environment.

Commercially available, the so-called 'spread-spectrum', clock oscillators can provide clock pulses with uniform frequency jitter. Some of the available products are listed below:

- Dallas Maxim DS1086 Spread-Spectrum EconOscillator
- Linear Technology LTC6902 Multiphase Oscillator with Spread Spectrum Modulation
- Epson SG-9001CA High-Frequency Crystal Oscillator with Spread Spectrum

In some applications, however, such as those disclosed in European Patent Application No. 05256583.5, filed 24 October 2005, it is the *period*, and not the frequency, that should be spread uniformly. Therefore, it would be advantageous to develop a technique for the generation of clock pulses with uniformly spread period.

One possible configuration of a spread-period clock generator is based on a well-known technique of converting voltage levels into time intervals with the use of a comparator whose one input is driven by a sequence of voltage ramps while the other (reference) input is kept at a threshold level which varies from ramp-to-ramp. In the ramp sequence, a new voltage ramp is generated each time the threshold level has been exceeded by the previous ramp. As a result, a sequence of time-varying intervals is produced, each interval being determined by two consecutive time marks occurring at the times when the two comparator inputs are of the same level.

Fig. 1 is a block diagram of a spread-period clock generator SPC disclosed in European Patent Application No. 05256583.5. The generator comprises a synchronous (K+1)-bit binary counter SBC driven by a suitable master clock generator CKG, a K-bit pseudorandom binary word generator BWG, a control unit CTU, a transition-matrix circuit TMX and a comparator CMR. Each state of the counter SBC can be regarded as a sign/magnitude representation of numbers: the most significant bit (MSB) represents the sign, and the remaining K bits constitute a binary representation of the magnitude.

The generator SPC produces pulses SP with uniform distribution of interpulse intervals in such a way that during each full cycle of operation, each interval value occurs exactly once. However, on separate cycles, the interval values may appear in different order due to a suitable permutation implemented by the transition-matrix circuit TMX.

Operations performed by the spread-period clock generator SPC to produce a single time interval are the following:

1. At the start of each interval, the pseudorandom binary word generator BWG in response to a pulse at input CK supplies a non-negative K-bit word {IK, ... , I2, I1} which is converted by the transition-matrix circuit TMX into another non-negative K-bit word {OK, ... , O2, O1} of value RN; hence, RN can assume one of the following values: 0, 1, ... , $2^K$-1.

2. The initial state of the counter SBC is set to some *negative* value -NV corresponding to the required shortest interpulse interval $T_{min} = (NV)T_c$, where $T_c$ is the period of clock pulses supplied by the CKG. The longest interpulse interval $T_{max}$ can be determined from $T_{max} = T_{min} + (2^K-1)T_c$.

3. The (K+1)-bit binary counter SBC is 'counting up' clock pulses obtained from the master clock generator CKG. Hence, its consecutive states are represented by the following values: -NV, -NV+1, -NV+2, .... Finally, as soon as the current state of the counter reaches the non-negative value RN, the comparator CMR produces a short pulse SP that:

- resets the counter SBC via input RS to its initial state -NV;
- prompts the pseudorandom binary word generator BWG via input CK to supply a new K-bit word.

The spread-period clock generator SPC operates continually, and the duration of each produced time interval is determined by time instants at which two consecutive pulses SP have occurred.

Because consecutive states of the counter SBC approximate digitally a linearly rising ramp and because binary words supplied by the pseudorandom binary word generator BWG are uniformly distributed, the distribution of the time intervals between consecutive pulses SP produced by the comparator CMR will also be uniform.

The pseudorandom binary word generator BWG may, for example, be a conventional K-stage shift register with linear feedback, an arrangement well known to those skilled in the art. In such a case, each word from the allowable range will occur exactly once during each cycle of operation, and the order of word appearance will depend on the form of employed feedback. A new word will be supplied in response to a pulse appearing at input CK.

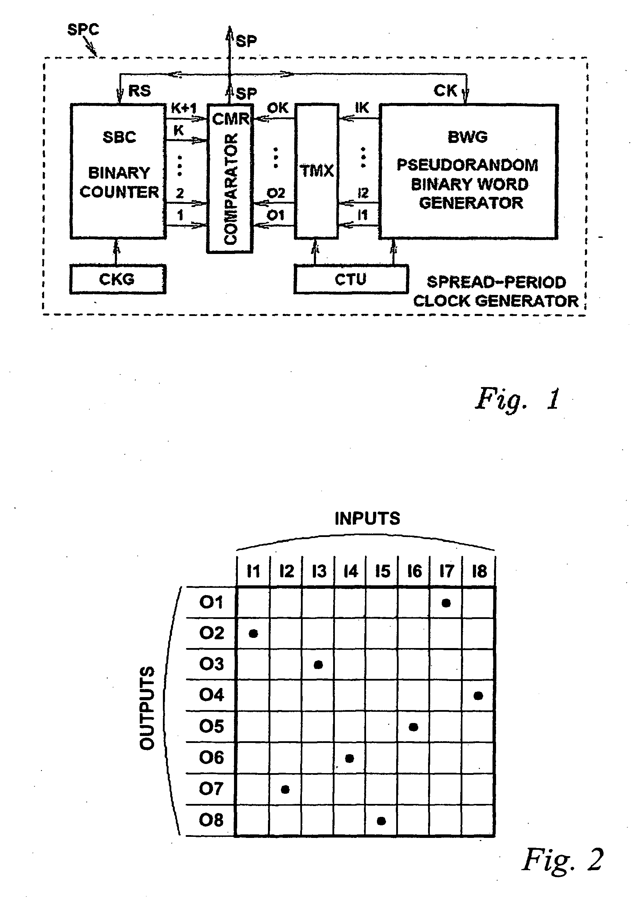

The operation of the circuit TMX can be explained by way of an example shown in Fig. 2. The pattern of 8 dots (K = 8) in the 8x8 matrix corresponds to input-output connections realized by the circuit TMX. Therefore, in this case, O1 = I7, O2 = I1, ... , O7 = I2 and O8 = I5. Obviously, each column and each row of the matrix must contain exactly one dot.

Although many different dot patterns can be devised for this application, it may be advantageous to utilize a dot pattern belonging to a class of patterns referred to as 'K non-attacking queens', such as the dot pattern shown in Fig. 2. Also, other well-known designs, such as those based on Costas arrays, may prove very useful in some specific applications.

In accordance with the above disclosure, a different dot pattern may be used for different cycles of the binary word generator BWG. A particular dot pattern may be selected from a predetermined set of patterns in a deterministic or non-deterministic fashion. The pattern selection task is carried out by the control unit CTU.

In addition to permutations obtained from changing the input-output connection matrix in the TMX, the form of feedback used by the generator BWG may also be varied. A particular feedback function can be selected from a predetermined set of functions in a deterministic or non-deterministic fashion. The feedback selection task is also carried out by the control unit CTU.

Previously proposed spread-period clock generators are capable of producing interpulse time intervals that may only assume integral multiplies of the master clock period. For example, when the master clock frequency is equal to 100 MHz, intervals between generated pulses may only assume values: 10 ns, 20 ns, 30 ns, etc. However, in practical applications, it would be advantageous to generate time intervals of duration being integral multiplies of a fraction (e.g., a half) of the master clock period, while still utilizing flip-flops operating at the same original switching speed.

US .2004/0263221 discusses a programmable dual-dege triggered counter for synthesizing clock signals with minimal jitter. The counter analyses an ongoing count to determine whther the rising edge of an output clock should be triggered by the rising edge or falling edge of an input clock signal, and to further determine whether the falling edge of the output clock should be triggered by the rising or the falling edge of the input clock signal.

SUMMARY OF THE INVENTION

Aspects of the present invention are set out in the accompanying claims.

A spread-period clock generator according to the invention counts basic clock pulses to generate output pulses with varying periods, and has means for switching between a first mode, in which counting is carried out in response to the leading edges of the basic clock pulses, and a second mode, in which counting is carried out in response to the trailing edges of the basic clock pulses. Accordingly, if mode switching is carried out during a counting operation, the counting period is altered by a portion of a basic clock period. Thus, the number of different periods of the output pulses can be increased without increasing the basic clock frequency and without glitches occurring in the output.

## BRIEF DESCRIPTION OF THE DRAWINGS

An arrangement embodying the present invention will now be described by way of example with reference to the accompanying drawings.

Fig. 1 is a block diagram of a spread-period clock generator SPC disclosed in European Patent Application No. 05256583.5.

Fig. 2 is an example of a transition matrix used in the generator of Fig. 1.

Fig. 3 is a block diagram of a spread-period clock generator according to the invention.

Fig. 4a is a circuit diagram of a clock waveform resolver/recombiner of the spread-period clock generator of Fig. 3.

Fig. 4b depicts waveforms generated in the clock waveform resolver/recombiner of Fig. 4a.

Fig. 5 is a diagram of a timing/control unit of the spread-period clock generator of Fig. 3.

Fig. 6 shows one example of a pseudorandom time-interval generator utilized by the spread-period clock generator of Fig. 3.

Fig. 7 depicts the fifteen allowable states of a register of the time-interval generator of Fig. 6.

Fig. 8a shows the waveforms at parts of the time-interval generator of Fig. 6

Fig. 8b shows the sequences of states of components of the time-interval generator of Fig. 6.

Fig. 9 is a complete diagram of the spread-period clock generator of Fig. 3.

Fig. 10 depicts a cyclic sequence of time intervals produced by the spread-period clock generator of Fig. 3.

Fig. 11 depicts one complete cycle of a pulse train obtained experimentally from a spread-period clock generator constructed in accordance with the invention.

## DETAILED DESCRIPTION OF THE PREFERRED EMBODIMENTS

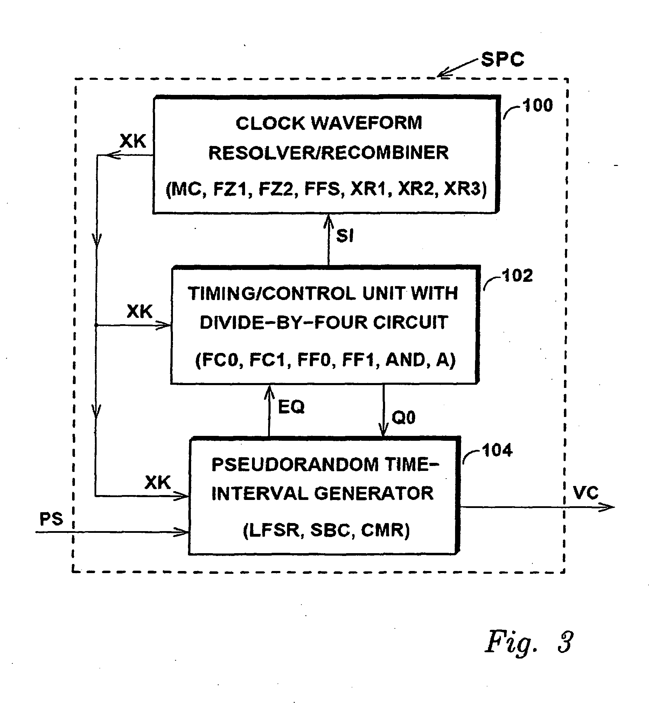

A spread-period clock generator arranged to operate in accordance with the present invention is shown in Fig. 3 and comprises three functional blocks:

1. a clock waveform resolver/recombiner - block 100;
2. a timing/control unit with a divide-by-four circuit - block 102;
3. a pseudorandom time-interval generator - block 104.

Fig. 3 shows the flow of timing and control signals between the functional blocks to indicate their interdependence. For reference purposes, each box that represents a functional block contains symbols identifying main components, such as flip-flops, logic gates and other circuits employed by the block.

*Pseudorandom time-interval generator 104*

Block 104 is arranged to implement a pseudorandom time-interval generator which is used in the present embodiment to constitute a variable time-interval generator. In the following, only one specific implementation of block 104 will be discussed in more detail, mainly to facilitate the understanding of the present invention. However, it will be obvious to those skilled in the art that suitable alterations, modifications, and variations will lead to functionally equivalent systems. For example, an arrangement functioning as described with reference to Fig. 1 could be used instead.

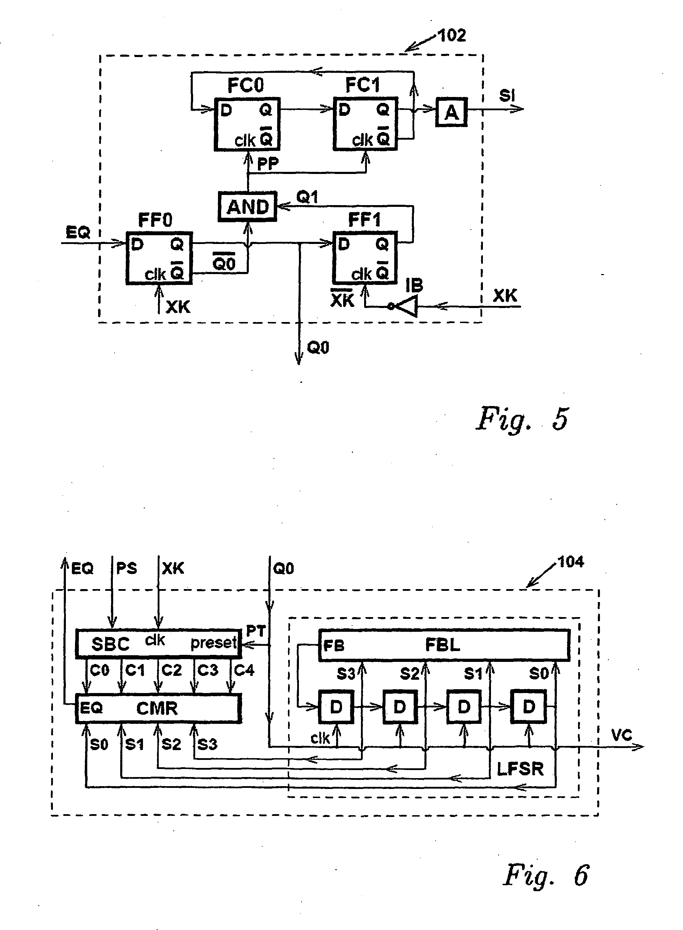

Fig. 6 is one example of a pseudorandom time-interval generator which can be utilized by the present embodiment. The generator 104 includes a four-stage linear feedback shift register LFSR, a five-bit synchronous binary counter SBC and a comparator CMR.

The register LFSR comprises four D-type flip-flops forming a shift register triggered by pulses Q0. The input of the shift register is driven by a feedback circuit FBL, which implements the following logic function

$$FB = \overline{S0} \oplus \overline{S1} + \overline{S0} \bullet \overline{S1} \bullet \overline{S2} \bullet \overline{S3}$$

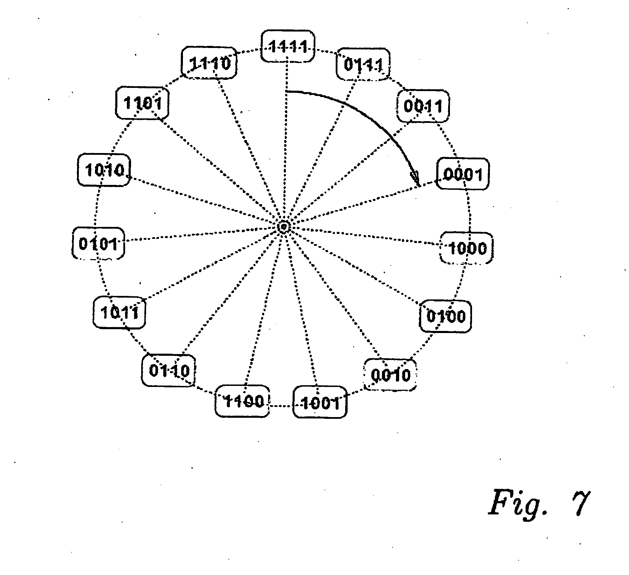

in which the second term is used to ensure self-start operation. Fifteen allowable states {S3, S2, S1, S0} of the register LFSR form one complete period of a cyclic sequence shown in Fig. 7.

The synchronous binary counter SBC may be implemented as a conventional synchronous five-bit binary counter; however, the equivalent function can be performed by a four-bit synchronous binary counter followed by a single toggle flip-flop supplying the most significant bit C4. The counter SBC is driven by counter clock pulses XK.

The counter SBC also uses a preset input PT to set the initial state of the counter to a predetermined state $\{C_0\}$ = {C4, C3, C2, C1, C0}, where C4 is the most significant bit (MSB) and C0 is the least significant bit (LSB). The initial state $\{C_0\}$ is chosen from a set of 'negative' states (i.e., those with C4 = 1) in response to a suitable binary word applied to 'preset select' input PS. It is assumed that the preset action occurs on the rising edge of a pulse Q0 appearing at input PT.

The comparator CMR is a combinatorial circuit implementing the logic function

$$EQ - \overline{C4} \bullet \overline{C3} \oplus S3 \bullet \overline{C2} \oplus S2 \bullet \overline{C1} \oplus \overline{S1} \bullet \overline{C0} \oplus \overline{S0}$$

The comparator receives four input values {S3, S2, S1, S0} from the register LFSR, and another five input values {C4, C3, C2, C1, C0} from the counter SBC. An output pulse (logic) signal EQ is supplied to a timing/control unit.

Varying time intervals are produced as follows:

While the register LFSR remains in one of the 15 allowable states, the counter SBC is 'counting up' clock pulses XK, thereby changing its state in response to each such pulse. The counting process starts from a selected initial SBC state $\{C_0\}$; then it runs continually, and terminates when the current counter state $\{C\}$ reaches an LFSR state, denoted by $\{S^*\}$, which remains steady during the entire counting process. At this time instant, i.e., when $\{C\} \equiv \{S^*\}$, the comparator CMR changes its logic state from '0' to '1', and a pulse corresponding to this transition is sent via output EQ to the timing/control unit 104.

Next, the register LFSR is advanced by a pulse Q0 to its *next* steady state $\{S^*\}$, the counter SBC is preset via input PT to its original initial 'negative' state $\{C_0\}$, and the entire procedure is repeated.

The spread-period clock generator operates continually, and the duration of each produced time interval is determined by the time instants at which two consecutive pulses Q0 have occurred at output VC.

*Timing/control unit 102*

A circuit diagram of block 102 is shown in Fig. 5. Block 102 comprises four D-type flip-flops (FF0, FF1, FC0, FC1), an inverting buffer IB, an AND gate (AND) and an auxiliary delay A.

Flip-flops FF0 and FF1 supply signals Q0 and Q1 that are used by the AND gate to generate a pulse PP that follows in a synchronous manner pulse EQ obtained from block 104. A sequence of pulses PP is employed as a clock signal by a divide-by-four circuit comprising flip-flops FC0 and FC1. An output waveform SI of the divider circuit is used to control the mode of operation of the counter clock generator (see below).

Block 102 also supplies a pulse Q0 used in block 104 to perform 'preset' and 'clock' functions.

*Clock waveform resolver/recombiner 100*

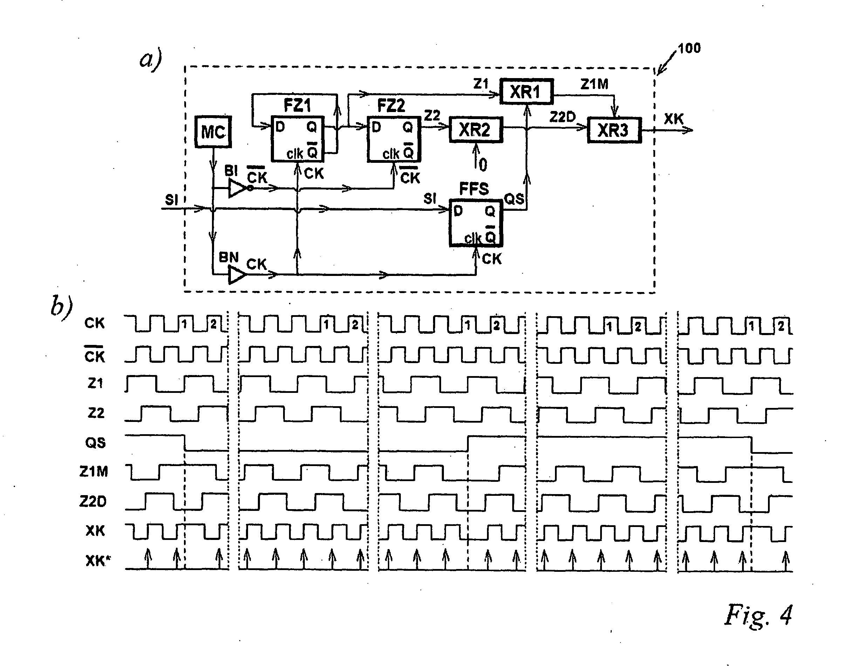

Fig. 4a is a circuit diagram of a clock waveform resolver/recombiner 100. All relevant waveforms are depicted in Fig. 4b.

Block 100 comprises a master (or basic) clock generator MC, and a counter clock generator is formed by an inverting buffer BI, a non-inverting buffer BN, three D-type flip-flops (FZ1, FZ2, FFS) and three Exclusive-OR gates (XR1, XR2, XR3).

The flip-flop FZ1 has a data input connected to its inverted output. The flip-flop FZ2 has a data input connected to the output of flip-flop FZ1. The master clock waveform CK and its inverted version are used to clock flip-flops FZ1 and FZ2, respectively, to produce binary waveforms Z1 and Z2 that can be regarded as two half-frequency 'digital cosine/sine' components of the master clock waveform. The waveform Z1 has edges produced in response to the rising edges of the basic clock waveform CK, which is applied to the clock input of the flip-flop FZ1. The edges of the waveform Z2 are produced in response to the trailing edges of the basic clock pulses CK, because the clock input of flip-flop FZ2 receives inverted clock pulses $\overline{CK}$.

The waveforms Z1 and Z2 are passed, respectively, through two Exclusive-OR gates, XR1 and XR2, to produce corresponding components, Z1M and Z2D. The Exclusive-OR gate XR1 has another input receiving a logic 0 level, so the component Z2D is simply a slightly delayed copy of Z2. The Exclusive-OR gate XR1 has another input receiving a signal QS, so the component Z1M, in addition to being slightly delayed with respect to Z1, will either be a copy of Z1 (when QS = 0), or an inverted (negated) copy of Z1 (when QS = 1).

The two waveforms Z1M and Z2D are combined by Exclusive-OR gate XR3 to generate waveform XK. The reconstructed waveform XK obtained at the output of gate XR3 will 'mirror' either the master clock waveform CK or its inversion. Thus, the rising edge of the counter clock pulses XK will be generated in response to the rising edge of the basic clock CK, or in response to the falling edge, depending on the mode of operation as controlled by the state of signal QS. Such an operation can be used to introduce a fixed delay step between consecutive rising edges of XK; those edges are shown symbolically in Fig. 4a as a sequence of impulses XK*. The waveform XK is utilized by blocks 102 and 104 as a counter clock pulse train with a stepped delay.

When the master clock waveform CK is symmetric (i.e., it has a unit mark/space ratio), the waveform Z1 is a $\pi/2$ phase-delayed version of waveform Z2. Also, the value of the fixed delay step which can be introduced into the pulse train XK* is equal to one half of the period of the master clock MC. For example, for master clock frequency of 100 MHz, the delay step will be equal to 5 ns.

The main role of gate XR2 is to compensate for the propagation delay introduced by gate XR1 in the path of component Z1; however, gate XR2 can also be employed to invert independently component Z2.

The fixed delay step is introduced in the reconstructed waveform XK each time the waveform QS changes its state. The waveform QS is supplied by flip-flop FFS in synchronism with clock CK. The flip-flop FFS is driven by a signal SI obtained from the divide-by-four circuit of the timing/control unit 102.

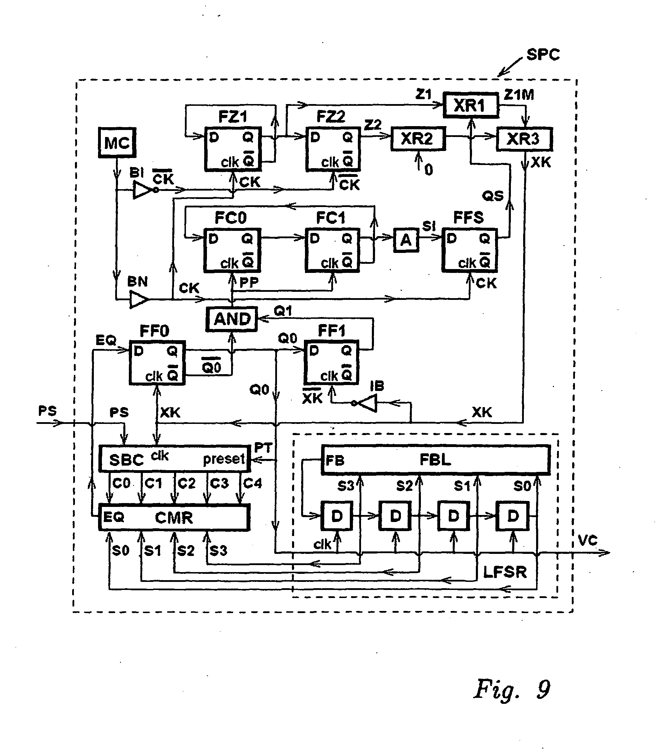

The above-described spread-period generator, shown in full in Fig. 9, operates as follows.

Each time the comparator CMR establishes that the counter SBC has reached the current set count established by the register LFSR, a signal EQ is sent to the timing/control unit 102. This is clocked into the flip-flop FF0 by the counter clock signal XK. The output of the flip-flop FF0 forms the signal Q0 used as described above to start a new counting cycle, in which the counter counts up to a new count set by the register LFSR.

The signal Q0 is also sent to the flip-flop FF1, which is clocked by an inverted version of the counter clock signal XK. The output of this flip-flop FF1 is the signal Q1 which is combined in the AND gate with signal Q0 to provide the output signal PP. The signal PP is a pulse which appears once after each counting cycle. This is divided by four using the flip-flops FC0 and FC1, and then delayed by delay A, to form signal SI. As indicated above, signal SI is clocked by the basic clock pulse CK in flip-flop FFS to form the signal QS used to switch the mode of the counter clock signal generator 100. The signal SI is slightly delayed by the auxiliary delay A to ensure a suitable set-up time for flip-flop FFS.

Because of this arrangement, a single cycle of the signal QS extends over four complete count operations, or cycles, of the counter SBC. Each state change of signal QS occurs shortly after the beginning of a new count cycle. The state changes occur in alternate count cycles, with no state change occurring in intervening count cycles (see Fig. 4).

Accordingly, for each steady state {S*} of the register LFSR, *two* different time intervals will be produced, in one of which a counter clock pulse XK is delayed by the change of state of the signal QS, and one in which no such delay occurs. Consequently, although one complete period of the linear-feedback shift register LFSR comprises 15 distinct states, the number of different time intervals produced by the system will be equal to 30 (also, because 15 and 2 are relative primes).

In order to facilitate the understanding of the operation of the embodiment, a specific example will now be considered.

***Example***

Assume that an initial 'negative' state {$C_0$} of the counter SBC has been selected as

$$\{C_0\} = \{1\ 1\ 1\ 0\ 1\}$$

Neither of the first four 'non-positive' counter states

$$\{1\ 1\ 1\ 0\ 1\},\ \{1\ 1\ 1\ 1\ 0\},\ \{1\ 1\ 1\ 1\ 1\},\ \{0\ 0\ 0\ 0\ 0\}$$

corresponds to one of the allowable 'positive' LFSR states; therefore, the shortest time interval will be obtained when $\{S^*\} = \{0\ 0\ 0\ 1\}$. The above four states will form the *preamble* associated with the selected initial SBC state $\{C_0\}$, which will determine the duration of the *shortest* time interval.

For example, if the frequency of the master clock MC equals 100 MHz, then the shortest time interval will be either 40 ns (if there is no delay in the pulse train XK) or 45 ns (if a delay step has been introduced into the pulse train XK).

Similarly, because the greatest value represented by an allowable LFSR state $\{S^*\}$ is

$$\{S^*\} = \{1\ 1\ 1\ 1\}$$

the longest time interval produced by the system will be either 180 ns (if there is no delay in the pulse train XK) or 185 ns (if a delay step has been introduced into the pulse train XK).

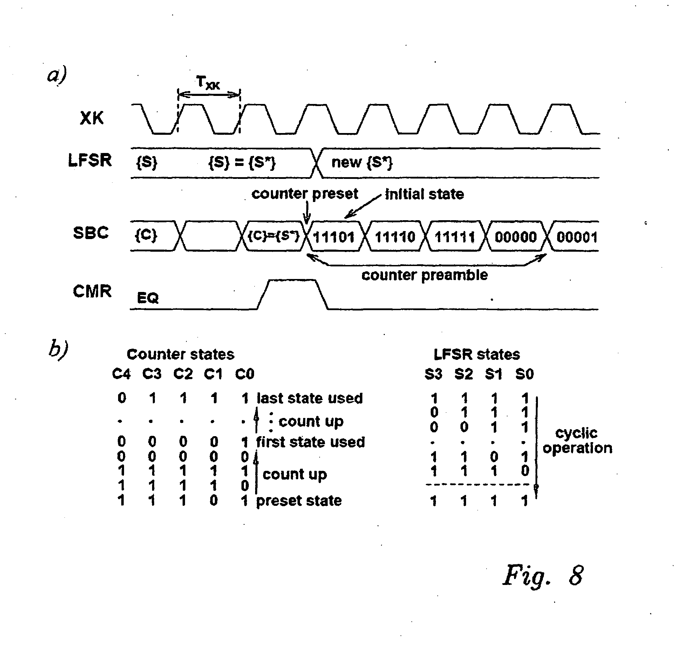

Fig. 8a depicts the waveforms produced by the shift register LFSR, the counter SBC and the comparator CMR. For reference purposes, Fig. 8b shows the sequences of states of both counter SBC and register LFSR.

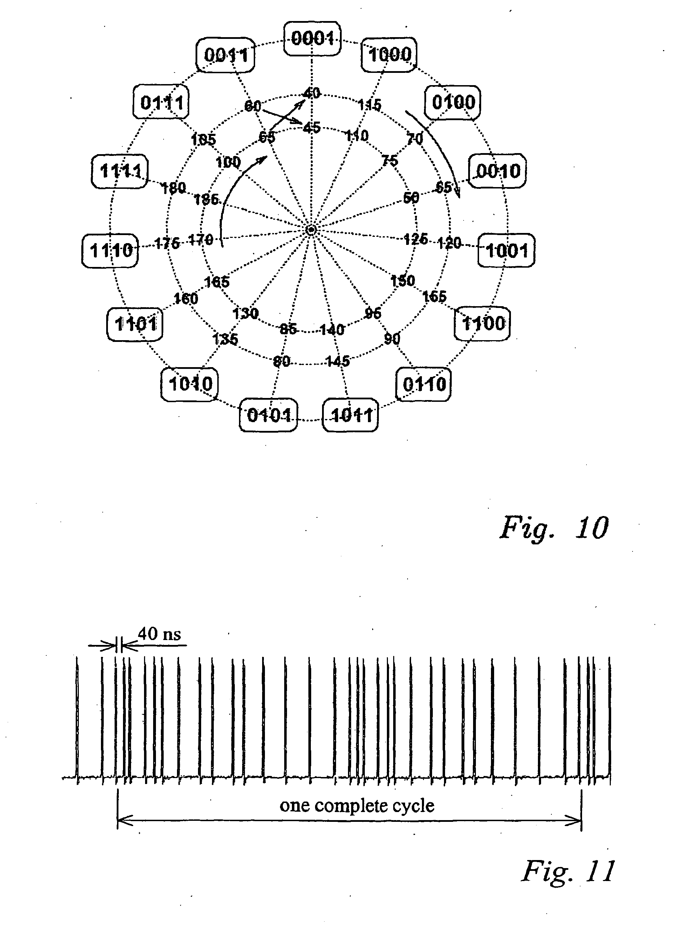

Fig. 10 depicts a cyclic sequence of interval values produced by the spread-period generator (the corresponding LFSR states are also shown for reference). Inspection of the diagram shown in Fig. 10 will reveal all the properties of the time intervals produced by the spread-period clock generator. The set counts successively established by the register LFSR are indicated in the outer circle and are presented in clockwise order. The intervals between output clocks are indicated by the inner two circles; the intervals in one inner circle occur in succession, followed by the intervals in the other inner circle. For each of the 15 set counts there are two intervals which differ by 5 nanoseconds.

Fig. 11 depicts one complete cycle of a pulse train obtained experimentally from the spread-period clock generator constructed in accordance with the invention. The sequence of time intervals observed within a single cycle, {40, 115, 70, 55, ... , 185, 100, 65}, measured in nanoseconds, follows the sequence of interval values shown in Fig. 10.

For visualization purposes, all the interval values can be placed on a suitable Möbius band to display both 'double-periodicity' of the values and their mutual dependence.

Both the shortest and the longest interval can be increased or decreased by the *same* amount by changing the initial 'negative' state $\{C_0\}$ of the counter SBC, thereby changing the preamble duration (as can be deduced from the state tables shown in Fig. 8b). The initial state $\{C_0\}$, chosen from a set of 'negative' states (i.e., those with C4 = 1), will be determined by a suitable binary word applied to 'preset select' input PS.

Although it is desirable that the distribution of the intervals between the output clocks be uniform, as in the above embodiment, this is not essential. Also, the intervals may be ordered or may be selected in a random or psuedo-random manner.

In the above arrangement, the basic clock signal CK is symmetric; however this is not essential. Accordingly, the phase difference between waveforms Z1 and Z2 may be different from π/2, in which case the magnitude of the introduced delay will depend on whether the signal QS changes to a high state or to a low state.

In the above arrangement, either no additional delay or a single delay is introduced during each count cycle. Instead, multiple delays of varying number may be introduced during each cycle. Also, it is not essential for every one of the possible set counts to give rise to two or more different interpulse delays.

The foregoing description of preferred embodiments of the invention has been presented for the purpose of illustration and description. It is not intended to be exhaustive or to limit the invention to the precise form disclosed. In light of the foregoing description, it is evident that many alterations, modifications, and variations will enable those skilled in the art to utilize the invention in various embodiments suited to the particular use contemplated.

**Claims**

**1.**  A spread-period clock generator, comprising:

a basic clock generator (MC) for generating basic clock pulses; and
means for counting basic clock pulses, in which in a first mode counting is carried out in response to the leading edges of the basic clock pulses and in a second mode counting is carried out in response to the trailing edges of the basic clock pulses; and
means for switching between the first mode and the second mode,

**characterised in that** the spread-period clock generator further comprises a counter' clock generator (BI,BN, FZ1,FZ2,XR1,XR2,XR3) for generating counter clock pulses (XK) in response to the basic clock pulses; wherein the switching means (FF0,FF1,FC0,FC1,A,FFS) is operable to switch the counter clock generator such that in said first mode one edge of each counter clock pulse is produced in response to the leading edge of a respective basic clock pulse, and in said second mode said one edge of each counter clock pulse is produced in response to the trailing edge of a respective basic clock pulse, whereby switching from one of said modes to the other of said modes alters the interval between said one edge of two successive counter clock pulses; and wherein said counting means comprising a counter (SBC) for counting in response to said counter clock pulses and a variable time-interval generator (LFSR,CMR,FF0) for producing an output pulse when a set count has been reached, the variable time-interval generator including means (LFSR) for varying the set count so as to vary the period of the output pulses.

2. A spread-period clock generator as claimed in claim 1, wherein the variable time-interval generator has means (PS) for setting a predetermined number of different set counts, the spread-period clock generator including means for controlling the switching of the mode of the count pulse generating means so that, for each set count, the mode is switched a different number of times during different counting operations, so that the number of different periods of the output pulses is at least twice said predetermined number.

3. A spread-period clock generator as claimed in claim 2, wherein, for each set count, the switching means is arranged to switch the mode once during one counting operation and not at all during a different counting operation.

4. A spread-period clock generator as claimed in any preceding claim, wherein the switching means is arranged to switch the mode a different number of times in successive counting operations.

5. A spread-period clock generator as claimed in any preceding claim, wherein the counter clock generator comprises means responsive to the basic clock signal for generating first and second signals which have twice the period of the basic clock signal and which differ in phase, and means for combining the first and second signals in an Exclusive-OR manner to generate the counter clock signal, the counter clock generator further comprising mode switching means for selectively inverting one of said first and second signals before the first and second signals are combined.

**Patentansprüche**

1. Taktgenerator mit verteilter Periode umfassend:

einen Grundtaktgenerator (MC) zum Erzeugen von Grundtaktimpulsen; und
Mittel zum Zählen von Grundtaktimpulsen, wobei das Zählen in einem ersten Modus in Reaktion auf die Vorderflanken der Grundtaktimpulse und das Zählen in einem zweiten Modus in Reaktion auf die Rückflanken der Grundtaktimpulse ausgeführt wird; und
Mittel zum Umschalten zwischen dem ersten und dem zweiten Modus,

**dadurch gekennzeichnet, dass** der Taktgenerator mit verteilter Periode ferner einen Gegentaktgenerator (BI,BN, FZ1,FZ2,XR1,XR2,XR3) zum Erzeugen von Gegentaktimpulsen (XK) in Reaktion auf die Grundtaktimpulse umfasst; wobei das Mittel zum Umschalten (FF0,FF1,FC0,FC1,A,FFS) betreibbar ist, um den Gegentaktgenerator derart umzuschalten, dass im ersten Modus eine Flanke jedes einzelnen Gegentaktimpulses in Reaktion auf die Vorderflanke eines entsprechenden Grundtaktimpulses produziert wird, und im zweiten Modus die Flanke jedes einzelnen Gegentaktimpulses in Reaktion auf die Rückflanke eines entsprechenden Grundtaktimpulses produziert wird, wobei das Umschalten von einem der Modi in einen anderen der Modi das Intervall zwischen der einen Flanke der zwei aufeinanderfolgenden Gegentaktimpulse ändert; und wobei das Mittel zum Zählen einen Zähler (SBC) zum Zählen in Reaktion auf die Gegentaktimpulse und einen variablen Zeitintervallgenerator (LFSR,CMR,FFO) zum Produzieren eines Ausgabeimpulses umfasst, wenn eine Set-Anzahl erreicht wurde, wobei der variable Zeitintervallgenerator Mittel (LFSR) zum Variieren der Set-Anzahl umfasst, um so die Periode der Ausgabeimpulse zu variieren.

2. Taktgenerator mit verteilter Periode nach Anspruch 1, wobei der variable Zeitintervallgenerator Mittel (PS) zum Festlegen einer vordefinierten Anzahl von unterschiedlichen Set-Anzahlen hat, wobei der Taktgenerator mit verteilter Periode Mittel zum Steuern des Umschaltens des Modus der Zählimpuls erzeugenden Mittel umfasst, so dass der Modus für jede einzelne Set-Anzahl verschiedene Male während unterschiedlicher Zählvorgängen umgeschaltet wird, sodass die Anzahl der verschiedenen Perioden der Ausgabeimpulse mindestens zweimal der vordefinierten Anzahl entspricht.

**3.** Taktgenerator mit verteilter Periode nach Anspruch 2, wobei das Umschaltmittel für jede Set-Anzahl so eingerichtet ist, um den Modus einmal während eines Zählvorgangs umzuschalten und überhaupt nicht während eines anderen Zählvorgangs.

**4.** Taktgenerator mit verteilter Periode nach einem der vorhergehenden Ansprüche, wobei das Umschaltmittel eingerichtet ist, um den Modus verschiedene Male in aufeinanderfolgenden Zählvorgängen umzuschalten.

**5.** Taktgenerator mit verteilter Periode nach einem der vorhergehenden Ansprüche, wobei der Gegentaktgenerator Mittel umfasst, die auf das Grundtaktsignal zum Erzeugen von ersten und zweiten Signalen reagieren, die zweimal die Periode des Grundtaktsignals aufweisen und die hinsichtlich der Phase abweichen, und Mittel zum Kombinieren der ersten und zweiten Signale in einer "Exklusiven ODER"-Methode, um das Gegentaktsignal zu erzeugen, wobei der Gegentaktgenerator ferner Modusumschaltmittel zum selektiven Invertieren eines der ersten und zweiten Signale umfasst, bevor die ersten und zweiten Signale kombiniert werden.

**Revendications**

**1.** Générateur d'horloge à étalement de période, comprenant :

un générateur d'horloge de base (MC) destiné à générer des impulsions d'horloge de base ; et
des moyens de comptage des impulsions d'horloge de base, dans lequel dans un premier mode, le comptage est effectué en réponse aux bords avant des impulsions d'horloge de base, et dans un deuxième mode, le comptage est effectué en réponse aux bords arrière des impulsions d'horloge de base ; et
des moyens destinés à commuter entre le premier mode et le deuxième mode,

**caractérisé en ce que** le générateur d'horloge à l'étalement de période comprend en outre un générateur d'horloge de compteur (BI, BN, FZ1, FZ2, XR1, XR2, XR3) destiné à générer des impulsions d'horloge de compteur (XK) en réponse aux signaux d'horloge de base ;
dans lequel les moyens de commutation (FFO, FFI, FC0, FC1, A, FFS) sont fonctionnels de manière à commuter le générateur d'horloge de compteur, de telle sorte que dans ledit premier mode, un bord de chaque impulsion d'horloge de compteur soit produit en réponse au bord avant d'une impulsion d'horloge de base respective, et dans ledit deuxième mode, ledit bord de chaque impulsion d'horloge de compteur soit produit en réponse au bord arrière d'une impulsion d'horloge de base respective, grâce à quoi la commutation à partir de l'un desdits modes vers l'autre desdits modes, modifie l'intervalle entre ledit un bord de deux impulsions d'horloge de compteur successives ; et dans lequel lesdits moyens de comptage comprennent un compteur (SBC) destiné à compter en réponse auxdites impulsions d'horloge de compteur, et un générateur d'intervalle de temps variable (LFSR, CMR, FFO) destiné à produire une impulsion de sortie quand un compte fixé a été atteint, le générateur d'intervalle de temps variable comprenant des moyens (LFSR) destinés à faire varier le compte fixé de manière à faire varier la période des impulsions de sortie.

**2.** Générateur d'horloge à étalement de période selon la revendication 1, dans lequel le générateur d'intervalle de temps variable présente des moyens (PS) destinés à fixer un nombre prédéterminé de différents comptes fixés, le générateur d'horloge à étalement de période comprenant des moyens destinés à commander la commutation du mode des moyens de génération d'impulsions de comptage de telle sorte que, pour chaque compte fixé, le mode soit commuté un nombre de fois différent au cours de différentes opérations de comptage, de telle sorte que le nombre des différentes périodes des impulsions de sortie, soit au moins le double dudit nombre prédéterminé.

**3.** Générateur d'horloge à étalement de période selon la revendication 2, dans lequel, pour chaque compte fixé, les moyens de commutation sont agencés de manière à commuter le mode une fois au cours d'une opération de comptage, et pas du tout au cours d'une opération de comptage différente.

**4.** Générateur d'horloge à étalement de période selon l'une quelconque des revendications précédentes, dans lequel les moyens de commutation sont agencés de manière à commuter le mode un nombre de fois différent dans des opérations de comptage successives.

5. Générateur d'horloge à étalement de période selon l'une quelconque des revendications précédentes, dans lequel le générateur d'horloge de compteur comprend des moyens sensibles au signal d'horloge de base afin de générer les premier et deuxième signaux qui présentent deux fois la période du signal d'horloge de base, et qui diffèrent en phase, et des moyens destinés à combiner les premier et deuxième signaux d'une façon en OU-Exclusif de manière à générer le signal d'horloge de compteur, le générateur d'horloge de compteur comprenant en outre des moyens de commutation de mode destinés à inverser de manière sélective l'un desdits premier et deuxième signaux avant que les premier et deuxième signaux ne soient combinés.

*Fig. 1*

*Fig. 2*

SPC

CLOCK WAVEFORM
RESOLVER/RECOMBINER

(MC, FZ1, FZ2, FFS, XR1, XR2, XR3)

100

XK

SI

TIMING/CONTROL UNIT WITH
DIVIDE-BY-FOUR CIRCUIT

(FC0, FC1, FF0, FF1, AND, A)

102

XK

EQ

Q0

PSEUDORANDOM TIME-
INTERVAL GENERATOR

(LFSR, SBC, CMR)

104

XK

PS

VC

*Fig. 3*

Fig. 4

*Fig. 5*

*Fig. 6*

*Fig. 7*

*a)*

*b)*

| | | | | | | | | | | |
|---|---|---|---|---|---|---|---|---|---|---|
| **Counter states** | | | | | | **LFSR states** | | | | |
| C4 | C3 | C2 | C1 | C0 | | S3 | S2 | S1 | S0 | |
| 0 | 1 | 1 | 1 | 1 last state used | | 1 | 1 | 1 | 1 | |
| · | · | · | · | · count up | | 0 | 1 | 1 | 1 | |
| 0 | 0 | 0 | 0 | 1 first state used | | 0 | 0 | 1 | 1 | cyclic operation |
| 0 | 0 | 0 | 0 | 0 | | · | · | · | · | |
| 1 | 1 | 1 | 1 | 1 count up | | 1 | 1 | 0 | 1 | |
| 1 | 1 | 1 | 1 | 0 | | 1 | 1 | 1 | 0 | |
| 1 | 1 | 1 | 0 | 1 preset state | | 1 | 1 | 1 | 1 | |

*Fig. 8*

Fig. 9

Fig. 10

Fig. 11

**EP 1 912 330 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 05256583 A
- US 20040263221 A